# EUROPEAN PATENT APPLICATION

(11) **EP 4 579 716 A1**
(43) Date of publication of application: **02.07.2025**
(21) Application number: 24218323.4
(22) Date of filing: 09.12.2024
(51) Int. Cl.: H01L 21/285

(54) **SEMICONDUCTOR DEVICE AND METHOD OF MANUFACTURING THE SAME**

(30) Priority: 27.12.2023 KR 20230193167; 05.09.2024 KR 20240121131
(71) Applicant: Samsung Electronics Co., Ltd., Suwon-si, Gyeonggi-do 16677 (KR)
(72) Inventor: NA, Byunghoon, 16678 Suwon-si (KR); KIM, Haeryong, 16678 Suwon-si (KR); PARK, Woonghyeon, 16678 Suwon-si (KR); LEE, Jaeho, 16678 Suwon-si (KR); LEE, Jooho, 16678 Suwon-si (KR)
(74) Representative: Elkington and Fife LLP

(57) **Abstract**

Provided is a semiconductor device. The semiconductor device includes a semiconductor layer including silicon, a first silicide layer in the semiconductor layer, and a second silicide layer provided on the first silicide layer. The first silicide layer includes a metal other than titanium, and the second silicide layer includes TiSi₂ having a C54 crystallization structure. A contact resistance of the semiconductor device may be reduced.

## Description

### FIELD OF THE INVENTION

Various example embodiments relate, in general, to a semiconductor device including a silicide layer that reinforces crystallization of the silicide layer and/or a method of manufacturing a semiconductor device.

### BACKGROUD OF THE INVENTION

A semiconductor device may include a junction of a metal and a semiconductor at a certain part of the semiconductor device; this junction may exchange electrical signals. This is because the metal has a relatively lower resistance as compared with the semiconductor and is easy to be wired to the outside. However, in this case, a contact resistance (Schottky resistance) occurs due to a heterojunction structure of the semiconductor/metal.

In order to reduce the contact resistance, various methods of reducing a Schottky energy barrier between a semiconductor and a metal have been suggested. For example, a metal having a work function of around 4 eV is used for an n-type semiconductor and a metal having a work function of around 5 eV may be used for a p-type semiconductor. However, because pinning of the work function of the metal on the surface of the semiconductor occurs, there is a limitation in reducing the Schottky energy barrier without consideration of the metal type. As another suggestion, a depletion width may be reduced by doping the surface of the semiconductor that comes into contact with the metal to have a high concentration. However, as semiconductor devices of smaller sizes are demanded, a doping concentration has to be further increased, but in such cases, there is a limitation in the method of increasing the doping concentration, the method of stably maintaining the doping status, and reducing the depletion width through an increase in the doping concentration.

### SUMMARY OF THE INVENTION

Provided is a semiconductor device including a first silicide layer that reinforces crystallization of a second silicide layer.

Provided is a method of manufacturing a semiconductor device including a first silicide layer for reinforcing crystallization of a second silicide layer.

Additional aspects will be set forth in part in the description which follows and, in part, will be apparent from the description, or may be learned by practice of the presented embodiments of the disclosure.

According to some example embodiments, a semiconductor device includes a semiconductor layer including silicon, a first silicide layer on the semiconductor layer; and a second silicide layer including titanium and having a crystallization structure on the first silicide layer, wherein the first silicide layer includes a metal other than titanium, and the second silicide layer includes TiSi₂ having a C54 crystallization structure.

The first silicide layer may include at least one of hafnium silicide, zirconium silicide, nickel silicide, and cobalt silicide.

The first silicide layer may have a thickness in a range of 3 Å to 30 Å.

The first silicide layer may have a crystalline structure.

The second silicide layer may have a thickness of 5Å to 70 Å.

The first silicide layer may include ZrSi, ZrSi₂, Zr₅Si₃, or Zr₃Si₂.

The second silicide layer may have a Schottky barrier height of 0.7 eV or less.

The semiconductor device may further include a metal layer on the second silicide layer.

The metal layer may include magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), argentum (Ag), cadmium (Cd), indium (In), tin (Sn), lanthanum (La), hafnium (Hf), tantalum (Ta), tungsten (W), iridium (Ir), platinum (Pt), aurum (Au), bismuth (Bi), or an arbitrary combination thereof.

The metal layer may include a source electrode arranged on one side surface of the channel layer and a drain electrode arranged facing another side surface of the channel layer, the second silicide layer may include a 2-1 silicide layer between the source electrode and the channel layer and a 2-2 silicide layer between the drain electrode and the channel layer, and the first silicide layer may include a 1-1 silicide layer between the 2-1 silicide layer and the channel layer and a 1-2 silicide layer between the 2-2 silicide layer and the channel layer.

The semiconductor layer may include a single-crystalline or polycrystalline structure.

The first silicide layer may be undoped.

The second silicide layer may be undoped.

The first silicide layer may be in direct contact with the semiconductor layer.

The first silicide layer may be in direct contact with the second silicide layer.

The semiconductor layer may include a well region doped to a first conductive type, and a source region and a drain region that are doped to a second conductive type that is electrically opposite to the first conductive type.

The semiconductor device may further include a gate electrode, and a gate insulating layer arranged on the gate electrode, wherein the semiconductor layer may include a channel layer arranged on the gate insulating layer.

The semiconductor layer may include a channel layer, and the semiconductor device may further include a gate insulating layer on an upper surface of the channel layer, and a gate electrode on the gate insulating layer.

Alternatively or additionally according to some example embodiments, a method of manufacturing a semiconductor device includes forming a semiconductor layer including silicon, forming a first silicide layer on the semiconductor layer, forming a second silicide layer including titanium on the first silicide layer, and crystallizing the second silicide layer, wherein the first silicide layer includes a metal other than titanium, and the second silicide layer includes TiSi₂ having a C54 crystallization structure.

The second silicide layer has a C54 crystallization structure within a range of 200°C to 400°C.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of a semiconductor device according to some example embodiments;
FIG. 2 is a diagram showing resistivity according to a temperature of titanium silicide with respect to thicknesses of 60 nm, 40 nm, and 25 nm of titanium silicide;
FIG. 3 is a diagram showing a crystallization degree of titanium silicide at about 400°C according to a comparative example;
FIG. 4 is a diagram showing a crystallization degree of titanium silicide at about 500°C according to a comparative example;
FIG. 5 is a diagram showing a crystallization degree of titanium silicide in a semiconductor device according to some example embodiments, with respect to thicknesses of 5 Å, 10 Å, and 20 Å of a first silicide layer;
FIG. 6 is a transmission electron microscope (TEM) image of a semiconductor device according to some example embodiments;
FIG. 7 is a TEM image of a semiconductor device according to some example embodiments;
FIG. 8 is a diagram showing a crystallization phase of titanium silicide in a semiconductor device according to some example embodiments;
FIG. 9 is a diagram showing a crystallization degree in a comparative example in which ZrSiₓ is arranged on a TiSiₓ layer;
FIG. 10 is a TEM image according to a comparative example, in which ZrSiₓ of a thickness of 2 nm is arranged on a TiSiₓ layer;
FIG. 11 is a TEM image according to a comparative example, in which ZrSiₓ of a thickness of 0.5 nm is arranged on a TiSiₓ layer;
FIG. 12 is a diagram for describing a method of manufacturing a semiconductor device, according to some example embodiments;
FIG. 13 is a schematic cross-sectional view of a field-effect transistor (FET) including a semiconductor device according to some example embodiments;
FIG. 14 is a schematic cross-sectional view of an FET including a semiconductor device according to some example embodiments;
FIG. 15 is a diagram schematically showing an image sensor including a semiconductor device according to some example embodiments;
FIG. 16 is a cross-sectional view schematically showing an FET according to some example embodiments;
FIG. 17 is a cross-sectional view schematically showing an FET according to some example embodiments;
FIG. 18 is a perspective view schematically showing an FET according to some example embodiments;
FIG. 19 is a cross-sectional view schematically showing a source/drain structure of FIG. 18;
FIG. 20 is a schematic block diagram of a display driver integrated circuit (IC) (DDI) and a display apparatus including the DDI, according to some example embodiments;
FIG. 21 is a circuit diagram of a complementary metal oxide semiconductor (CMOS) inverter according to some example embodiments;
FIG. 22 is a circuit diagram of a CMOS static random-access memory (SRAM) device according to some example embodiments;
FIG. 23 is a circuit diagram of a CMOS NAND circuit according to some example embodiments;
FIG. 24 is a block diagram of an electronic apparatus according to some example embodiments; and
FIG. 25 is a block diagram of an electronic apparatus according to some example embodiments.

### DETAILED DESCRIPTION

Reference will now be made in detail to various embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device according to some example embodiments is described in detail with reference to accompanying drawings. In the drawings, like reference numerals denote like components, and sizes of components in the drawings may be exaggerated for convenience of explanation. It will be understood that although the terms "first" and "second" are used herein to describe various elements, these elements should not be limited by these terms. Terms are only used to distinguish one element from other elements.

An expression used in the singular encompasses the expression of the plural, unless it has a clearly different meaning in the context. It will be further understood that when a portion is referred to as "comprising" another component, the portion may not exclude another component but may further comprise another component unless the context states otherwise. Also, in the drawings, a size or thickness of each component may be exaggerated for clarity of description. In the following description, when a layer is described to exist on another layer, the layer may exist directly on a substrate or the other layer or another layer may be interposed therebetween. In addition, because materials forming each layer in the following embodiments are exemplary, other materials may be used.

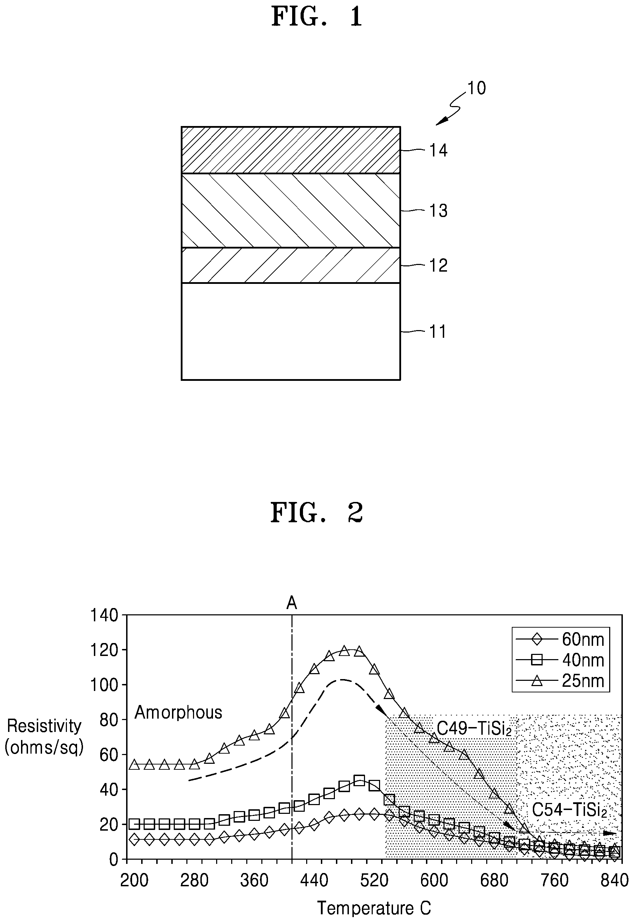

FIG. 1 is a diagram schematically showing a semiconductor device 10 according to some example embodiments.

The semiconductor device 10 may include a semiconductor layer 11, a first silicide layer 12 provided on the semiconductor layer 11 and including a first silicide, and a second silicide layer 13 provided on the first silicide layer 12.

The semiconductor layer 11 may include silicon (Si), e.g. single-crystal silicon. The semiconductor layer 11 may form various regions of the semiconductor device 10. The semiconductor device 10 may be applied to, for example, one or more of a transistor such as a field effect transistor (FET), a semiconductor memory device, a logic device, an image sensor, etc., and the semiconductor layer 11 may be used as source/drain regions, a channel region, etc. of the devices. The semiconductor layer 11 may be an undoped layer, an n-type doping layer, or a p-type doping layer. When the semiconductor layer 11 is an n-type doping layer, the semiconductor layer 11 may include at least one dopant from arsenic (As), phosphorous (P), and an antimony (Sb). When the semiconductor layer 11 is a p-type doping layer, the semiconductor layer 11 may include boron (B) dopant. The semiconductor layer 11 may include single-crystalline silicon or polycrystalline silicon. In some cases, the semiconductor layer 11 may be or may correspond to an n-type doping layer that includes n-type dopants and p-type dopants at a concentration much lower than that of n-type dopants; in some cases, the semiconductor layer 11 may be or may correspond to a p-type doping layer that includes p-type dopants and n-type dopants at a concentration much lower than that of p-type dopants.

The first silicide layer 12 may reinforce and prompt the crystallization of the second silicide layer 13. The first silicide layer 12 may include a material having a lower crystallization temperature than that of the second silicide layer 13. The first silicide layer 12 may include, for example, at least one of hafnium silicide (HfSiₓ), zirconium silicide (ZrSiₓ), nickel silicide (NiSiₓ), and cobalt silicide (CoSiₓ). Alternatively or additionally, the first silicide layer 12 may include, for example, ZrSi, ZrSi₂, Zr₅Si₃, or Zr₃Si₂.

The second silicide layer 13 may include metal and silicon. For example, the second silicide layer 13 may include Ti and silicon. The second silicide layer 13 may include TiS₂. In addition, the first silicide layer 12 may include titanium (Ti) and another metal.

The first silicide layer 12 may induce the second silicide layer 13 to be thin and to be crystallized at a low temperature. The first silicide layer 12 may include, for example, zirconium silicide (ZiₓSi_{y}) so as to prompt the crystallization of the second silicide layer 13 even with a small thickness at a relatively low temperature. When the first silicide layer 12 include ZrₓSi_{y}, the first silicide layer 12 may include ZrSi, ZrSi₂, Zr5Si3, or Zr₃Si₂. Alternatively or additionally, the first silicide layer 12 may be disposed between the semiconductor layer 11 and the second silicide layer 13. Alternatively, an upper surface of the first silicide layer 12 may be in direct contact with a lower surface of the second silicide layer 13. Alternatively or additionally, a lower surface of the first silicide layer 12 may be in direct contact with the semiconductor layer 11, and the upper surface of the first silicide layer 12 may be in direct contact with the second silicide layer 13.

The second silicide layer 13 may have a thickness of 70 Å or less. For example, the second silicide layer 13 may have a thickness in a range of 5 Å to 70 Å. For example, the second silicide layer 13 may have a thickness in a range of 5 Å to 50 Å. However, it is difficult to crystallize the second silicide layer 13 while reducing the thickness of the second silicide layer 13 as described above. This may be because, when the thickness is reduced the crystallization process may easily damage the second silicide layer 13. However, when crystallizing the second silicide layer 13 having the thickness of 70 Å or less, the crystallization of the second silicide layer 13 may be reinforced and prompted by the first silicide layer 12, and thus, the second silicide layer 13 may be crystallized at a relatively low temperature and the damage to the second silicide layer 13 or another layer, which may occur at a high temperature, may be prevented or reduced in likelihood of occurrence and/or in impact from occurrence. For example, as compared with the case in which there is no first silicide layer 12, the crystallization temperature of the second silicide layer 13 may be decreased, and when the crystallization layer is decreased, the damage to the second silicide layer 13 during crystallizing the second silicide layer 13 having reduced thickness may be prevented or reduced in likelihood of occurrence and/or in impact from occurrence. The crystallization temperature of the second silicide layer 13 may be 500°C or less. For example, the crystallization temperature of the second silicide layer 13 may be 450°C or less. For example, the crystallization temperature of the second silicide layer 13 may be 400°C or less. For example, the crystallization temperature of the second silicide layer 13 may be in a range of 200°C to 400°C.

The metal layer 14 may be further provided on the second silicide layer 13. The metal layer 14 may be located opposite to the first silicide layer 12 based on the second silicide layer 13. The metal layer 14 may be provided to be in direct contact with the second silicide layer 13. However, the metal layer 14 is not limited thereto. The metal layer 14, for example, may be used as an electrode layer. The metal layer 14 may include magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), argentum (Ag), cadmium (Cd), indium (In), tin (Sn), lanthanum (La), hafnium (Hf), tantalum (Ta), tungsten (W), iridium (Ir), platinum (Pt), aurum (Au), bismuth (Bi), or any combination thereof.

As a semiconductor memory device or logic device adopting the semiconductor device 10 is reduced in size and an area thereof decreases, it is necessary or desirable to maintain ohmic characteristics even in a narrow area in order to maintain device performances. In order to maintain the ohmic characteristics, the metal layer 14 should have a low resistivity as well as a low contact resistance. However, in a junction structure of the semiconductor layer 11 and the metal layer 14, a Schottky barrier height occurs on the bonding surface between silicon and the metal layer 14 due to a pinning effect generated on the bonding surface, which causes high contact resistance. Here, the second silicide layer 13 is provided between the metal layer 14 and the silicon semiconductor layer 11 so as to reduce the Schottky barrier height on the bonding surface between the silicon semiconductor layer 11 and the metal layer 14, and thus, the contact resistance may be reduced. Alternatively or additionally, because the second silicide layer 13 has excellent resistivity property, the resistance characteristics between the semiconductor layer 11 including Si and the metal layer 14 may be improved. The second silicide layer 13 may improve the resistance characteristics by including titanium silicide (TiSiₓ). Because titanium silicide has relatively excellent thermal stability and/or low resistivity, titanium silicide may be efficiently applied as a contact material of a silicon-based semiconductor device. Because the second silicide layer 13 has one or more of low work function, low resistivity, and good crystal coherency with respect to the silicon semiconductor layer 11, the second silicide layer 13 may be used as an intermediate resistive material between the silicon semiconductor layer 11 and the metal layer 14.

The first silicide layer 12 may reduce the crystallization temperature of the second silicide layer 13 and may allow the second silicide layer 13 to have a crystalline phase. When the second silicide layer 13 includes titanium silicide (TiSiₓ), the second silicide layer 13 may have a C54 crystalline structure. Because the crystallization temperature of the second silicide layer 13 is reduced, negative influence of the high temperature on the other layers during the processes of manufacturing/fabricating the semiconductor device 10 may be reduced, and the semiconductor device 10 may have high conductivity. Alternatively or additionally, the first silicide layer 12 prompts the crystallization of the second silicide layer 13 at a relatively low temperature even when the thickness of the second silicide layer 13 is reduced, and thus, the second silicide layer 13 may have the C54 crystalline structure. As such, the Schottky barrier height of the second silicide layer 13 may be decreased. For example, the second silicide layer 13 may have a Schottky barrier height of 0.7 eV or less. Alternatively or additionally, the second silicide layer 13 may have a Schottky barrier height within a range of 0.3 eV to 0.7 eV. Also, the first silicide layer 12 may have a crystalline structure, not an amorphous structure.

Hereinafter, an example in which the second silicide layer 13 includes titanium silicide (TiSi₂) is described in more detail.

Titanium silicide may have, for example, C49 crystalline structure or C54 crystalline structure during a crystallization process.

FIG. 2 shows a change in a resistivity according to a temperature, with respect to the cases in which a thickness of a titanium silicide layer is 25 nm, 40 nm, and 60 nm. FIG. 2 shows an example in which titanium silicide layer is crystallized without using the first silicide layer 12. Line A denotes a process limiting temperature of a semiconductor device including titanium silicide layer. As the thickness of the titanium silicide layer decreases, the resistivity increases. When the thickness of the titanium silicide layer is 40 nm or 60 nm, the resistivity is relatively low even while being in an amorphous state. In addition, when the thickness of the titanium silicide layer is 25 nm, a C49 crystalline structure is formed at a temperature of about 500°C or greater, and the resistivity is high, that is, about 20 ohms/sq or greater. The C54 crystalline structure is formed at the temperature of about 700°C or greater, and in this case, the resistivity decreases to 20 ohms/sq or less. In the case of titanium silicide, the C49 crystalline structure is formed at the relatively low temperature, e.g., about 500°C, but the C54 crystalline structure exhibiting a resistance lower than that of the C49 structure is formed at the high temperature of about 700°C. Because the C49 crystalline structure has a lower activation energy than that of the C54 crystalline structure, in the crystallization of titanium silicide, nucleation is likely to be performed to have the C49 crystalline structure, rather than the C54 crystalline structure. As such, a packing density of the titanium silicide of the C54 crystalline structure becomes less than that of the C49 crystalline structure, and due to the low packing density, a volume shrinking issue may occur during a post-processing operation such as an annealing and/or other thermal processing such as low-pressure chemical vapor deposition (LPCVD) steps. Because it is difficult to crystallize due to the high crystallization temperature of the C54 crystalline structure and the crystallization temperature of the C54 structure is greatly increased as the thickness is reduced, the titanium silicide layer has been used in an amorphous form even though the resistance is higher than that of the C54 crystalline structure. Alternatively or additionally, the C54 crystalline structure has been formed at a relatively low temperature by inserting a small amount of Mo, Ta, Nb, etc. into the titanium silicide (TiSiₓ) in order to reduce the crystallization temperature, but the resistivity increases, and moreover, the crystallization is not made with thin thickness.

As described above, titanium silicide has better resistance characteristics in the C54 crystalline structure or phase as compared with the C49 crystalline structure or phase. However, due to the high activation energy of the C54 crystalline structure, the crystallization may not be performed sufficiently when the silicon semiconductor layer 11 and the second silicide layer 13 including titanium are bonded to each other. At the relatively low temperature, e.g., about 500°C, the C49 crystalline structure is obtained, but the C49 crystalline structure shows high resistivity characteristic and high contact resistance when bonding to the silicon semiconductor layer 11. On the contrary, titanium silicide (TiSiₓ) in the C54 crystalline structure has better resistance characteristic than that of the C49 crystalline structure. However, because the crystallization temperature of the C54 crystalline structure is greater than that of the C49 crystalline structure, other layers are negatively influenced during the crystallization process and the overall performance of the semiconductor device degrades.

Thus, according to some example embodiments, the first silicide layer 12 including a crystallization driving intermediate material is disposed between the silicon semiconductor layer 11 and the second silicide layer 13, and accordingly, the crystallization of the second silicide layer 13 may be sufficiently performed even with the reduced thickness. Because the first silicide layer 12 has high reactivity with silicon in the semiconductor layer 11, the crystallization activation energy of the second silicide layer 13 is greatly reduced, and the crystallization stability may be improved.

The first silicide layer 12 may be silicide including metal and silicon. The first silicide layer 12 may include a metal other than titanium. The metal layer 14 may be or may include a nitride-based metal layer such as TiN, WN, MoN, etc. Alternatively or additionally, the metal layer 14 may include at least one of Mo, Ru, Co, Ti, and W.

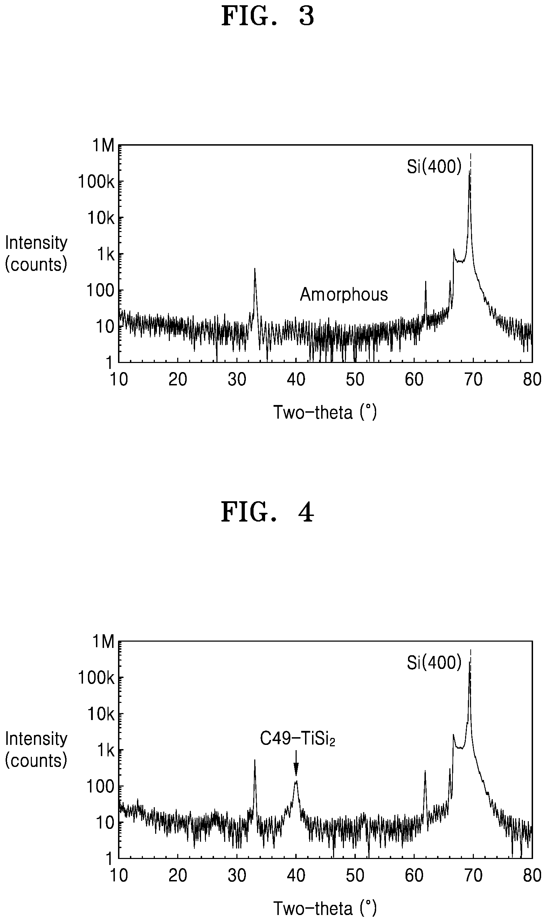

FIG. 3 is a diagram showing a crystalline shape of the titanium silicide having no first silicide layer 12 at about 400°C according to a comparative example, based on an X-ray diffraction (XRD) and reflection high-energy electron diffraction (RHEED) analysis. A graph of FIG. 3 shows an optical intensity according to two-theta that is a crystallization specified angle. A crystalline structure of a corresponding material may be identified according to a peak value at a certain angle. Referring to FIG. 3, titanium silicide of the comparative example shows an amorphous characteristic. This denotes that titanium silicide (TiSiₓ) is not crystallized at a low temperature of about 400°C due to the high activation energy. FIG. 4 is a diagram showing crystalline shape of titanium silicide (TiSiₓ) at a temperature of about 500°C, based on the XRD and RHEED analysis. At a relatively high temperature of 500°C, the crystallization of titanium silicide (TiSiₓ) was identified during growth through the RHEED, but according to the XRD analysis, the C49 crystalline structure having high resistance was identified.

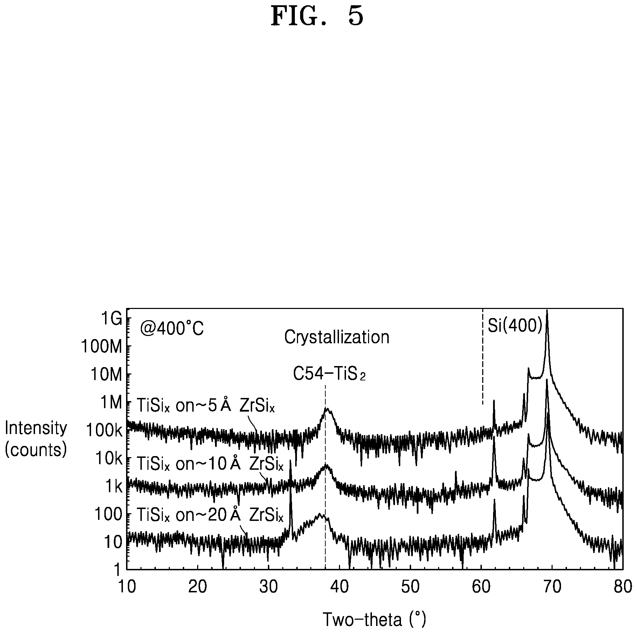

FIG. 5 is a diagram showing a crystallization degree in the case in which the first silicide layer 12 is disposed between the semiconductor layer 11 and the second silicide layer 13, according to some example embodiments. Here, the first silicide layer 12 includes ZrSi₂. The examples in which the thickness of the first silicide layer 12 is 5 Å, 10 Å, and 20 Å, are shown. In FIG. 5, graphs are shown to be spaced from one another without regard to the intensity in order to show the examples in which the thickness of the first silicide layer 12 is 5 Å, 10 Å, and 20 Å along with each other, for convenience of description. When the first silicide layer 12 has the thickness of 5 Å, 10 Å, and 20 Å, the titanium silicide has the C54 crystalline structure. When the first silicide layer 12 is very small in terms of thickness, the titanium silicide (TiSi₂) may have the C54 crystalline structure. The first silicide layer 12 may have a thickness of, for example, 3 Å to 30 Å. For example, the first silicide layer 12 may have a thickness of 3 Å to 20 Å. For example, the first silicide layer 12 may have a thickness of 5 Å to 20 Å.

Referring to FIG. 5, when growing the second silicide layer 13 at the temperature of about 400°C, crystallization of titanium silicide (TiSiₓ) was identified through RHEED. According to the XRD analysis, the crystalline phase of the titanium silicide (TiSiₓ) has low-resistance C54 crystalline structure. The thickness of titanium silicide (TiSiₓ) may be 70 Å or less. In the semiconductor device 10 according to some example embodiments, the second silicide layer 13 may have single crystalline phase. For example, the second silicide layer 13 may have the C54 crystalline structure.

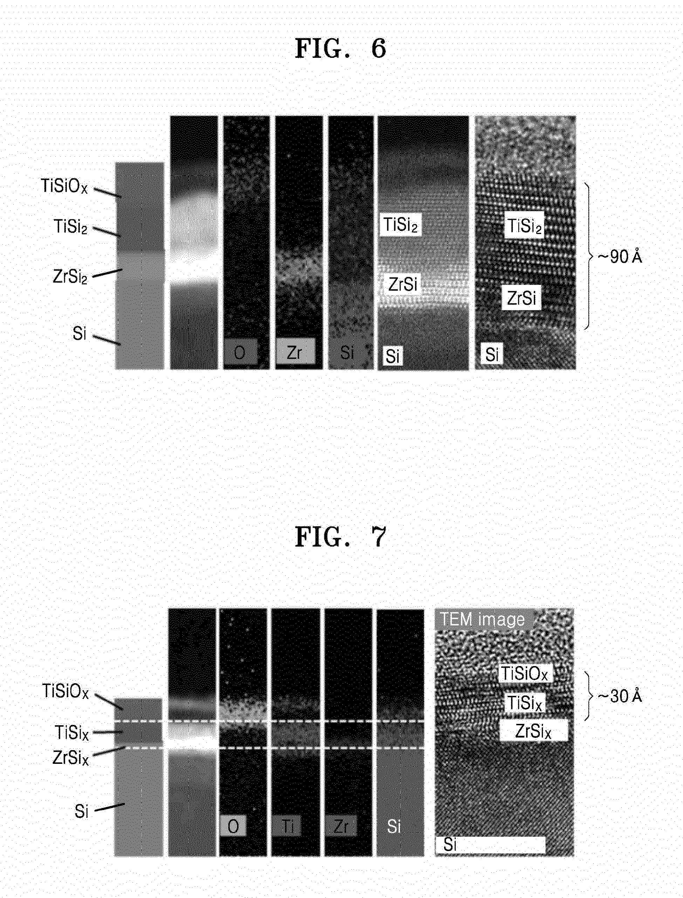

FIG. 6 is a transmission electron microscope (TEM) image of a semiconductor device when the first silicide layer 12 includes ZrSix having a thickness of 20 Å. The TEM image shows that the Si semiconductor layer 11, ZrSi₂ first silicide layer 12, and TiSi₂ second silicide layer 13 are stacked, and that a crystalline structure is formed. A TiSiOₓ layer denotes an oxide layer that is generated when being exposed to the atmosphere after stacking the semiconductor device. The TiSiOₓ layer is not a component in the semiconductor device according to some example embodiments. Here, a total thickness of the ZrSi₂ first silicide layer 12, the TiSi₂ second silicide layer 13, and the TiSiOₓ layer may be about 90 Å.

FIG. 7 is a TEM image of a semiconductor device when the first silicide layer 12 includes ZrSiₓ having a thickness of 5 Å. The TEM image shows that the Si semiconductor layer 11, the first silicide layer 12 including ZrSiₓ, and the second silicide layer 13 including TiSiₓ are stacked, and that a crystalline structure is formed. Here, a total thickness of the first silicide layer 12 including ZrSiₓ, the second silicide layer 13 including TiSiₓ, and the TiSiOₓ layer may be about 30 Å. As described above, when the first silicide layer 12 is very small in terms of thickness, the second silicide layer 13 including TiSiₓ may be crystallized.

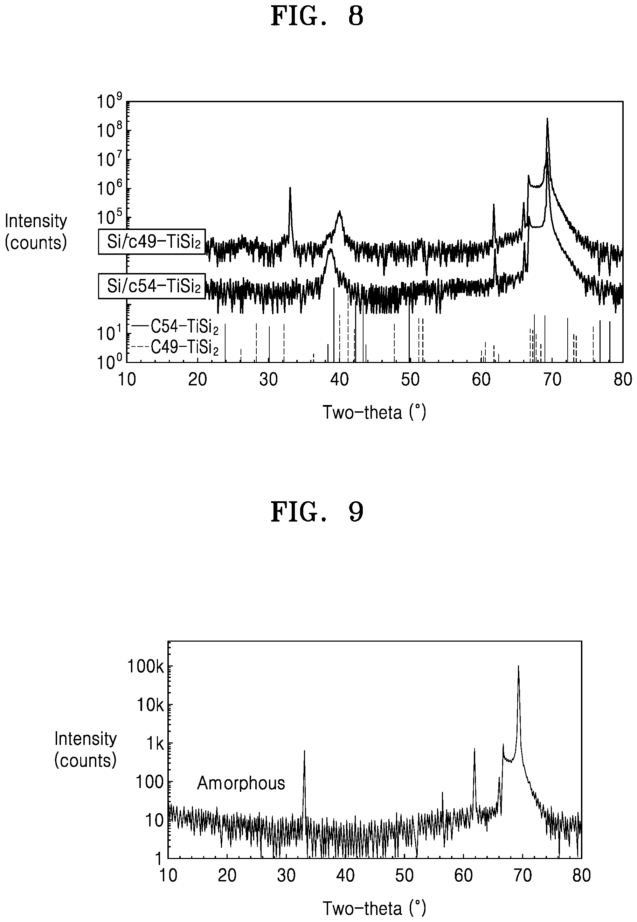

FIG. 8 is a diagram showing a C49-TiSi₂ crystalline structure and C54-TiSi₂ crystalline structure in the semiconductor device according to some example embodiments. C54-TiSi₂ has a peak at angle of crystallization of about 40°C two-theta.

Next, a comparative example in which zirconium silicide (ZrSiₓ) is stacked on titanium silicide is described below. That is, a ZrSiₓ layer is not disposed between the silicon layer and the TiSiₓ layer, but is arranged on the TiSiₓ layer. FIG. 9 shows a crystallization degree when a structure, in which a TiₓSi_{y} layer having a thickness of 2 nm, a ZrₓSi_{y} layer having a thickness of 0.5 nm, and a TiₓSi_{y} layer having a thickness of 5 nm are sequentially stacked at a temperature of 200°C or less, is annealed for 30 minutes at the temperature of 200°C and the temperature of 400°C. In FIG. 9, the crystalline structure of titanium silicide is not shown, but the amorphous state is shown. In other words, when the position of the ZrSiₓ layer corresponding to the first silicide layer 12 is changed to the upper portion of the second silicide layer 13, the TiSiₓ layer was not crystallized at the temperature of about 400°C.

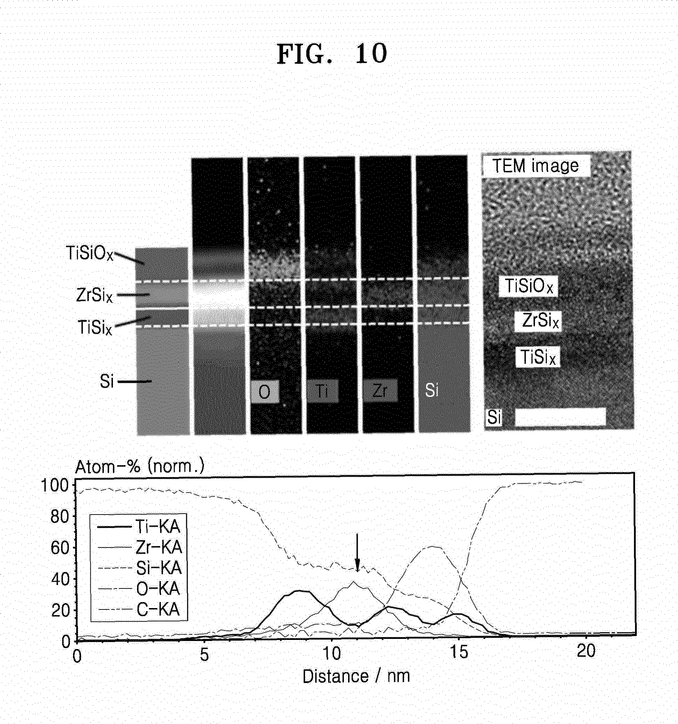

FIG. 10 shows a TEM image and an EDS line-scan of a comparative example having a Si/TiSiₓ/ZrSiₓ stack structure and an atomic% according to the distance of the stack structure. ZrSiₓ has a thickness of 2 nm. TiSiₓ has a thickness of about 2 nm. Here, TiSiOₓ denotes an oxide layer that is oxidated when the stack structure is crystallized. Referring to the TEM image, the TiSiₓ layer is not crystallized.

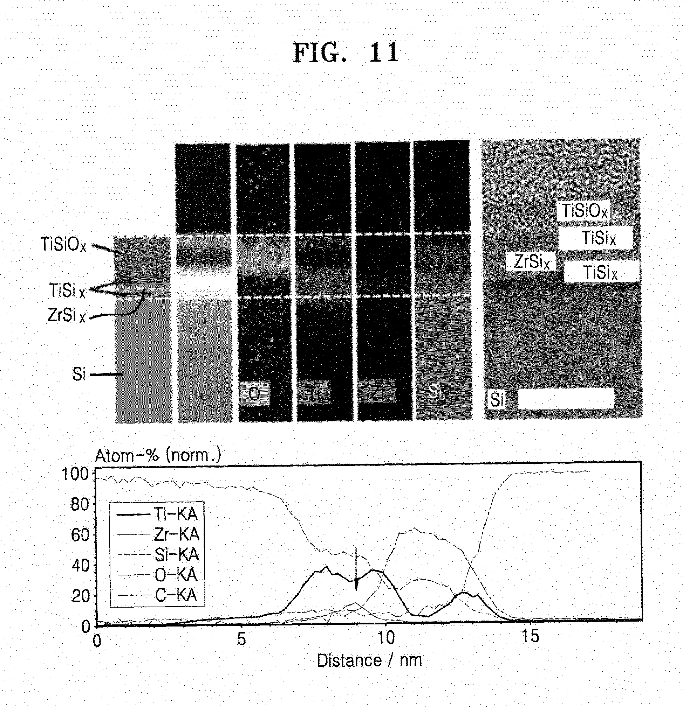

FIG. 11 shows a TEM image and an EDS line-scan of a comparative example having a Si/TiSiₓ/ZrSiₓ/TiSiₓ stack structure and an atomic% according to the distance of the stack structure. ZrSiₓ has a thickness of about 0.5 nm. TiSiₓ has a thickness of about 0.5 nm. Referring to the TEM image, the TiSiₓ layer was not crystallized.

Referring to FIGS. 10 and 11, when the ZrSiₓ layer corresponding to the first silicide layer is located on the TiSi layer and the thickness thereof is reduced or when the ZrSiₓ layer is located between two TiSiₓ layers, the TiSiₓ layer is not crystallized. When the thin ZrSiₓ layer is provided between two TiSiₓ layers, similar effects as those obtained from the TiSiₓ layer doped with Zr may be obtained. Even when the TiSiₓ layer is doped with a dopant such as Zr, it may be difficult to crystallize the TiSiₓ layer.

In the semiconductor device 10 according to some example embodiments, the first silicide layer 12 may be an undoped layer. Also, the second silicide layer 13 may be an undoped layer. When the second silicide layer 13 is an undoped layer, the second silicide layer 13 may have lower specific resistance and lower Schottky barrier as compared with a doped silicide. At the same time, the first silicide layer 12 may have a C54 crystallization structure at a relatively low temperature. However, the first silicide layer 12 and the second silicide layer 13 are not limited thereto, and a dopant may be used as necessary or desirable.

The semiconductor device 10 according to some example embodiments includes the first silicide layer 12 between the silicon semiconductor layer 11 and the second silicide layer 13, and thus, the crystallization may be possible even with very thin second silicide layer 13 and at a relatively low temperature. When there is no first silicide layer 12, the titanium silicide of the semiconductor device 10 according to some example embodiments may have a C54 crystallization structure of the same thickness within a temperature range in which the titanium silicide has the C49 crystallization structure. As such, the contact resistance of the Si-based semiconductor device 10 that is miniaturized may be reduced, and negative influences on the other layers of the semiconductor device 10 during the crystallization process may be reduced, thereby improving the performance of the semiconductor device 10.

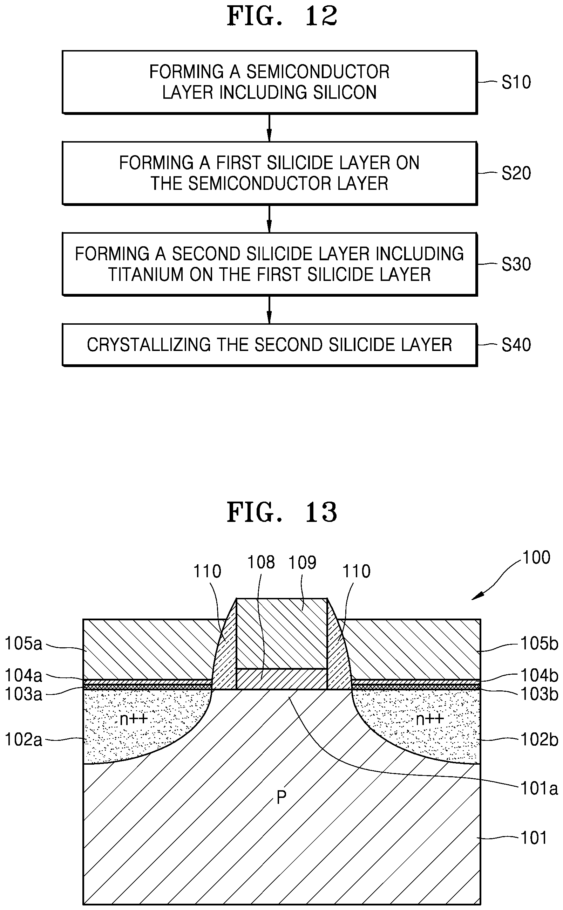

FIG. 12 is a diagram for describing a method of manufacturing a semiconductor device, according to some example embodiments.

Referring to FIGS. 12 and 1, the method of manufacturing the semiconductor device includes forming the semiconductor layer 11 including silicon (S10). In addition, the first silicide layer 12 is formed on the semiconductor layer 11 (S20). The first silicide layer 12 may include a metal other than titanium. The second silicide layer 13 including titanium is formed on the first silicide layer 12 (S30). In addition, the second silicide layer 13 may be crystallized through a thermal process. The first silicide layer 12 prompts the crystallization of the second silicide layer 13 so that the second silicide layer 13 may have the C54 crystallization structure at a relatively low temperature. The second silicide layer 13 may include TiSi₂ that has the C54 crystallization structure within a temperature range of 200°C to 400°C. The second silicide layer 13 may have a thickness ranging from 5 Å to 70 Å.

The semiconductor device 10 manufactured by the manufacturing method according to some example embodiments may have the reduced contact resistance and may be applied to a next-generation semiconductor memory device and/or a logic device.

A logic device is responsible for operation and control, and a memory device is responsible for storing information. The logic device may be applied to one or more of a micro-component, an analog integrated circuit (IC), a logic IC, etc. The analog IC may include one or more of a power semiconductor, an image sensor, a touch controller, etc. The logic IC may include a display driver IC (DDI), a timing controller (T-CON), a media IC, an application processor (AP), semiconductor for a vehicle, etc. The memory device may include one or more of DRAM, SRAM, NAND memory, etc.

The semiconductor device 10 described above may be applied to various apparatuses such as a field-effect transistor (FET), etc. For example, FIG. 13 is a cross-sectional view schematically showing an FET 100 according to some example embodiments. Referring to FIG. 13, the FET 100 may include a well region 101 doped to a first conductive type, a source region 102a doped to a second conductive type that is electrically opposite to the first conductive type, a drain region 102b doped to the second conductive type, a 1-1 silicide layer 103a disposed on the source region 102a, a 1-2 silicide layer 103b disposed on the drain region 102b, a 2-1 silicide layer 104a disposed on the 1-1 silicide layer 103a, a 2-2 silicide layer 104b disposed on the 1-2 silicide layer1-2 silicide layer 103b, a source electrode 105a disposed on the 2-1 silicide layer 104a, a drain electrode 105b disposed on the 2-2 silicide layer 104b, a gate insulating layer 108 disposed on the well region 101, and a gate electrode 109 disposed on the gate insulating layer 108.

As compared with FIG. 1, the source region 102a and the drain region 102b may correspond to the semiconductor layer including silicon. The 2-1 silicide layer 104a and the 2-2 silicide layer 104b may include metal and silicon. The 2-1 silicide layer 104a and the 2-2 silicide layer 104b may include titanium silicide (TiSiₓ). The 1-1 silicide layer 103a and the 1-2 silicide layer 103b may each include at least one of HfSiₓ, ZrSiₓ, NiSiₓ, and CoSiₓ. The 1-1 silicide layer 103a and the 1-2 silicide layer 103b may include at least one of ZrSi, ZrSi₂, Zr₅Si₃, or Zr₃Si₂.

In FIG. 13, the well region 101 is doped to a p-type, and the source region 102a and the drain region 102b are doped to an n-type. However, some example embodiments is not limited thereto, and the well region 101 may be doped to an n-type and the source region 102a and the drain region 102b may be doped to a p-type. Further in some example embodiments, other impurities such as but not limited to group IV impurities such as one or more of carbon, silicon, or germanium may be doped and incorporated into either or both of the source region 102a and the drain region 102b. Alternatively, the source region 102a and the drain region 102b may be undoped. The well region 101 may be doped to a relatively low concentration of about 10¹⁴~10¹⁸/cm³, and the source region 102 and the drain region 102b may be doped to a relatively high concentration of about 10¹⁹/cm³ in order to reduce the depletion width. In some example embodiments, a halo/pocket region (not show) may be included in or near the source region 102a and/or the drain region 102b; however, example embodiments are not limited thereto.

The source region 102a and the drain region 102b may be arranged on opposite side surfaces on the upper portion of the well region 101. For example, after forming the well region 101 by doping a semiconductor substrate to p-type, opposite sides on an upper surface of the semiconductor substrate are doped to n-type to form the source region 102a and the drain region 102b. The well region 101 may include a channel region 101a between the source region 102a and the drain region 102b. The channel region 101a may be doped to the first conductive type, like the well region 101. The source region 102a and the drain region 102b may be arranged spaced apart from each other with the channel region 101a therebetween. Here, the source region 102a and the drain region 102b may correspond to the semiconductor layer 11 of FIG. 1. In other words, when the FET 100 of FIG. 13 corresponds to the semiconductor device 10 of FIG. 1, the semiconductor layer 11 may include the source region 102a and the drain region 102b.

The 1-1 silicide layer 103a and the 1-2 silicide layer 103b may be arranged spaced apart from each other with the gate insulating layer 108 therebetween.

The 2-1 silicide layer 104a and the 2-2 silicide layer 104b may reduce (e.g. further reduce) the contact resistance. The 2-1 silicide layer 104a and the 2-2 silicide layer 104b may be arranged spaced apart from each other with the gate insulating layer 108 therebetween. The 2-1 silicide layer 104a and the 2-2 silicide layer 104b may correspond to the second silicide layer 13 of FIG. 1. In other words, when the FET 100 of FIG. 13 corresponds to the semiconductor device 10 of FIG. 1, the second silicide layer 13 may include the 2-1 silicide layer 104a and the 2-2 silicide layer 104b.

The 1-1 silicide layer 103a may accelerates the crystallization of the 2-1 silicide layer 104a and the 1-2 silicide layer 103b may accelerate the crystallization of the 2-2 silicide layer 104b. The lower surface of the 1-1 silicide layer 103a may be in direct contact with the source region 102a and the upper surface of the 1-1 silicide layer 103a may be in direct contact with the 2-1 silicide layer 104a. Also, the lower surface of the 1-2 silicide layer 103b is in direct contact with the drain region 102b and the upper surface of the 1-2 silicide layer 103b may be in direct contact with the 2-2 silicide layer 104b.

A source electrode 105a on the 2-1 silicide layer 104a and a drain electrode 105b on the 2-2 silicide layer 104b may correspond to the metal layer 14 of FIG. 1. In other words, when the FET 100 of FIG. 13 corresponds to the semiconductor device 10 of FIG. 1, the metal layer 14 may include the source electrode 105a and the drain electrode 105b. The source electrode 105a and the drain electrode 105b may be arranged spaced apart from each other with a gate electrode 109 therebetween.

The gate insulating layer 108 may be arranged on the upper surface of the well region 101, and in particular, the upper surface of the channel region 101a. The gate insulating layer 108 may include at least one dielectric material from SiO₂, SiNₓ, HfO₂, and Al₂O₃. The gate electrode 109 disposed on the gate insulating layer 108 may include polysilicon such as doped polysilicon and/or a metal material that is the same as that included in the source electrode 105a and the drain electrode 105b.

The FET 100 may further include a spacer 110 surrounding the side walls of the gate insulating layer 108 and the gate electrode 109. The spacer 110 may prevent the gate insulating layer 108 and the gate electrode 109 from coming into direct contact with the source electrode 105a and the drain electrode 105b. The spacer 110 may include an insulating material such as SiO₂, SiNₓ, etc.

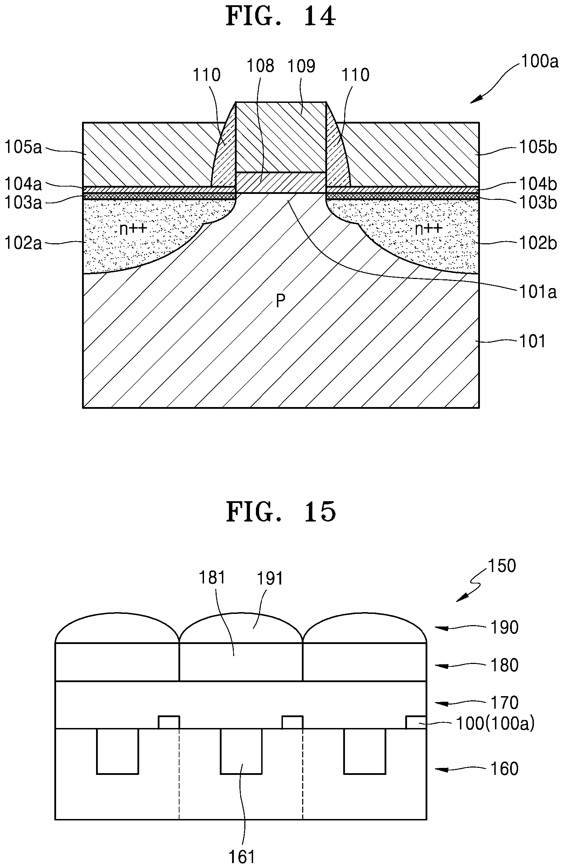

FIG. 14 is a cross-sectional view schematically showing an FET 100a according to some example embodiments. In the FET 100 of FIG. 13, the upper surfaces of the well region 101, the source region 102a, and the drain region 102b are located at the same plane, and the first and second silicide layers 104a and 104b may extend to come into contact with the side wall of the spacer 110. On the contrary, in the FET 100a of FIG. 14, the first and second silicide layers 104a and 104b may extend to come into contact with the lower surface of the spacer 110. To this end, the upper surface of the well region 101 may be formed higher than the upper surfaces of the source region 102a and the drain region 102b. The first and second silicide layers 104a and 104b may extend to an interface between the spacer 110 and the gate insulating layer 108 along the lower surface of the spacer 110. In this case, the 1-1 silicide layer 103a and the 1-2 silicide layer 103b may also extend to the interface between the spacer 110 and the gate insulating layer 108.

The FET 100 or 100a may be adopted in an image sensor (however, example embodiments are not limited thereto). FIG. 15 is a diagram schematically showing an image sensor 150. The image sensor 150 includes an optical sensor array 160 in which optical sensors 161 for sensing light are to be arranged, a color filter array 180 in which color filters 181 for filtering light according to colors are arranged, a micro-lens array 190 in which micro-lenses 191 for focusing light according to pixels are arranged, and a driving layer 170 including the transistor 100 or 100a. The image sensor 150 may generate an electrical image signal based on an intensity of the incident light. The image sensor 150 may be applied to various multimedia devices having image capturing functions. The image sensor 150 may be applied to a camera in a mobile phone, a smartphone, a tablet, a smart tablet, a laptop computer, etc.

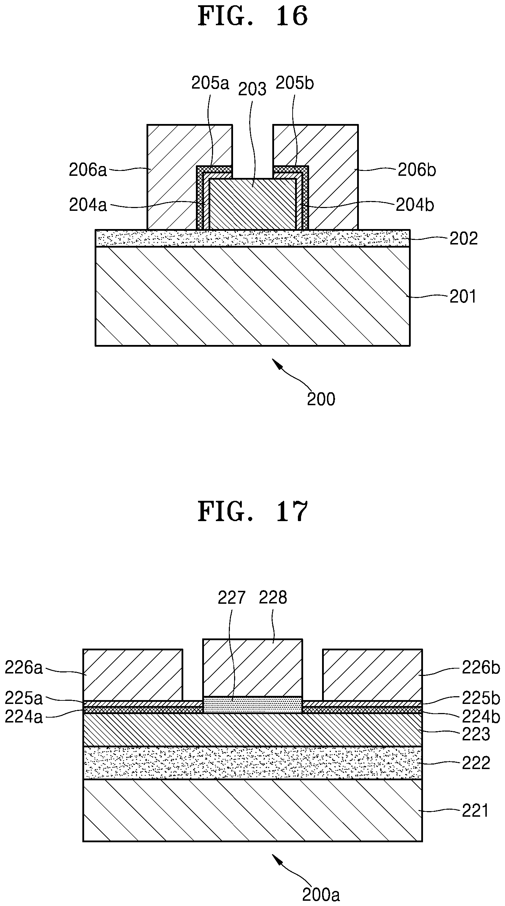

FIG. 16 is a cross-sectional view schematically showing an FET 200 according to some example embodiments. Referring to FIG. 16, the FET 200 may include a gate electrode 201, a gate insulating layer 202 disposed on the gate electrode 201, a channel layer 203 disposed on the gate insulating layer 202, a source electrode 206a arranged on one side of the channel layer 203 to be electrically in contact with the channel layer 203, a drain electrode 206b which is arranged on another side of the channel layer 203 to be electrically in contact with the channel layer 203, a 2-1 silicide layer 205a disposed between the channel layer 203 and the source electrode 206a, a 2-2 silicide layer 205b disposed between the channel layer 203 and the drain electrode 206b, a 1-1 silicide layer 204a disposed between the 2-1 silicide layer 205a and the channel layer 203, and a 1-2 silicide layer 204b disposed between the 2-2 silicide layer 205b and the channel layer 203.

The channel layer 203 may correspond to the semiconductor layer 11 of FIG. 1. For example, when the FET 200 of FIG. 16 corresponds to the semiconductor device 10 of FIG. 1, the semiconductor layer 11 may include the channel layer 203 arranged on the gate insulating layer 202. The channel layer 203 may include undoped silicon.

The source electrode 206a and the drain electrode 206b may correspond to the metal layer 104 of FIG. 1. For example, when the FET 200 of FIG. 16 corresponds to the semiconductor device 10 of FIG. 1, the metal layer 14 may include the source electrode 206a and the drain electrode 206b.

The 2-1 silicide layer 205a and the 2-2 silicide layer 205b may correspond to the second silicide layer 13 of FIG. 1. In other words, when the FET 200 of FIG. 16 corresponds to the semiconductor device 10 of FIG. 1, the second silicide layer 13 may include the 2-1 silicide layer 205a and the 2-2 silicide layer 205b. The 2-1 silicide layer 205a may extend from one side surface to a part of the upper surface of the channel layer 203. In some example embodiments, the 2-2 silicide layer 205b may extend from another side surface to another part of the upper surface of the channel layer 203, so as not to come into contact with the 2-1 silicide layer 205a. Therefore, the 2-1 and 2-2 silicide layers 205a and 205b may be bent by about 90° between the side and upper surfaces of the channel layer 203.

The 1-1 silicide layer 204a and the 1-2 silicide layer 204b may correspond to the first silicide layer 12 of FIG. 1. In other words, when the FET 200 of FIG. 16 corresponds to the semiconductor device 10 of FIG. 1, the first silicide layer 12 may include the 1-1 silicide layer 204a and the 1-2 silicide layer 204b. The 1-1 silicide layer 204a may extend from one side surface to a part of the upper surface of the channel layer 203. In some example embodiments, the 1-2 silicide layer 204b may extend from another side surface to another part of the upper surface of the channel layer 203, so as not to come into contact with the 1-1 silicide layer 204a. Therefore, the 1-1 silicide layer 204a and the 1-2 silicide layer 204b may be bent by about 90° between the side and upper surfaces of the channel layer 203.

FIG. 17 is a cross-sectional view schematically showing an FET 200a according to some example embodiments. The FET 200 of FIG. 16 has a lower gate structure in which the gate electrode 201 is arranged under the channel layer 203, but the FET 200a of FIG. 17 differs from the FET 200 in that the FET 200a has an upper gate structure. Referring to FIG. 17, the FET 200a may include a substrate 221, an insulating layer 222 arranged on the upper surface of the substrate 221, a channel layer 223 arranged on the upper surface of the insulating layer 222, a gate insulating layer 227 arranged in a part on the upper surface of the channel layer 223, a gate electrode 228 arranged on the upper surface of the gate insulating layer 227, 1-1 silicide layer and 1-2 silicide layer 224a and 224b arranged respectively on different regions of the upper surface of the channel layer 223, a 2-1 silicide layer 225a arranged on the upper surface of the 1-1 silicide layer 224a, a 2-2 silicide layer 225b arranged on the upper surface of the 1-2 silicide layer 224b, a source electrode 226a arranged on the upper surface of the 2-1 silicide layer 225a, and a drain electrode 226b arranged on the upper surface of the 2-2 silicide layer 225b.

The channel layer 223 may correspond to the semiconductor layer 11 of FIG. 1. In other words, when the FET 200a of FIG. 17 corresponds to the semiconductor device 10 of FIG. 1, the semiconductor layer 11 may include the channel layer 223 arranged on the insulating layer 222. The channel layer 223 may include undoped silicon.

When the FET 200a of FIG. 17 corresponds to the semiconductor device 10 of FIG. 1, the first silicide layer 12 may include the 1-1 silicide layer 224a and the 1-2 silicide layer 224b. The 1-1 silicide layer 224a and the 1-2 silicide layer 224b may be arranged spaced apart from each other with the gate insulating layer 227 therebetween. The lower surface of the 1-1 silicide layer 224a may be in direct contact with the channel layer 223, and the upper surface of the -1 silicide layer 224a may be in direct contact with the 2-1 silicide layer 225a. Also, the lower surface of the 1-2 silicide layer 224b may be in direct contact with the channel layer 223, and the upper surface of the 1-2 silicide layer 224b may be in direct contact with the 2-2 silicide layer 225b.

The second-1 silicide layer 225a and the second-2 silicide layer 225b may correspond to the second silicide layer 13 of FIG. 1. In other words, when the FET 200a of FIG. 17 corresponds to the semiconductor device 10 of FIG. 1, the second silicide layer 13 may include the second-1 silicide layer 225a arranged on the 1-1 silicide layer 224a and the 2-2 silicide layer 225b arranged on the 1-2 silicide layer 224b. The 2-1 silicide layer 225a and the 2-2 silicide layer 225b may be arranged spaced apart from each other with the gate insulating layer 227 therebetween.

The source electrode 226a and the drain electrode 226b may correspond to the metal layer 104 of FIG. 1. In other words, when the FET 200a of FIG. 17 corresponds to the semiconductor device 10 of FIG. 1, the metal layer 14 may include the source electrode 226a arranged on the 2-1 silicide layer 225a and the drain electrode 226b arranged on the 2-2 silicide layer 225b. The source electrode 226a and the drain electrode 226b may be arranged spaced apart from each other with a gate electrode 228 therebetween.

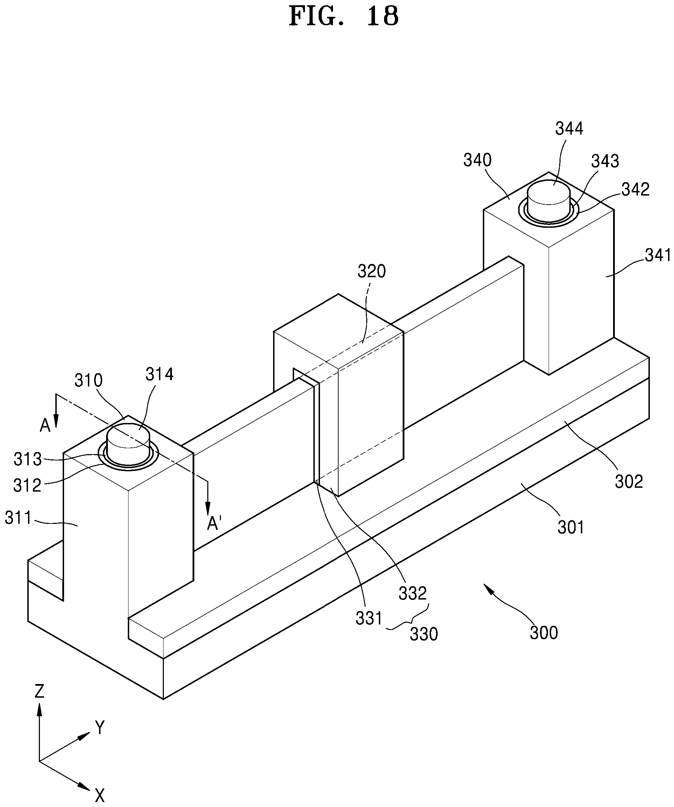

FIG. 18 is a perspective view schematically showing an FET 300 according to some example embodiments. Referring to FIG. 18, the FET 300 may include a substrate 301, a source structure 310 protruding from the upper surface of the substrate 301 in a Z direction, a drain structure 340 protruding from the upper surface of the substrate 301 in the Z direction, a channel 320 protruding from the upper surface of the substrate 301 in the Z direction and having a bar shape extending in a Y direction, and a gate structure 330 covering the channel 320 so as to surround the channel 320. The FET 300 may further include an isolation layer 302 for electrically isolating from another adjacent FET that is not shown in the drawing. The isolation layer 302 includes an insulating dielectric material and may be arranged to extend in the Y direction along the opposite side surfaces of the source structure 310, the channel 320, the gate structure 330, and the drain structure 340 on the upper surface of the substrate 301. The FET 300 of FIG. 18 may include, for example, a fin field-effect transistor (FinFET).

The channel 320 may extend in the Y direction and then may be connected between the source structure 310 and the drain structure 340. In other words, a first end portion of the channel 320 may be in contact with the source structure 310 and a second end portion of the channel 320 may be in contact with the drain structure 340. The channel 320 may include P-type silicon semiconductor doped to a relatively low concentration or N-type silicon semiconductor doped to a relatively low concentration.

The gate structure 330 may include a gate insulating layer 331 covering the channel 320 between the source structure 310 and the drain structure 340, and a gate electrode 332 covering the gate insulating layer 331. The gate insulating layer 331 may protrude from the upper surface of the substrate 301 so as to cover three surfaces of the channel 320, that is, opposite side surfaces and the upper surface of the channel 320. Also, the gate electrode 332 may protrude from the upper surface of the substrate 301 so as to cover three surfaces of the gate insulating layer 331, that is, opposite side and upper surfaces of the gate insulating layer 331.

The source structure 310 may include a semiconductor layer 311, a source electrode 314 arranged in the semiconductor layer 311, a second silicide layer 313 arranged in the semiconductor layer 311 so as to surround the source electrode 314, and a first silicide layer 312 including first silicide arranged in the semiconductor layer 311 so as to surround the second silicide layer 313. Likewise, the drain structure 340 may include a semiconductor layer 341, a drain electrode 344 arranged in the semiconductor layer 341, a second silicide layer 343 arranged in the semiconductor layer 341 so as to surround the drain electrode 344, and a first silicide layer 342 arranged in the semiconductor layer 341 so as to surround the second silicide layer 343.

The semiconductor layer 311 of the source structure 310 and the semiconductor layer 341 of the drain structure 340 may be arranged to protrude from the upper surface of the substrate 301 in the Z direction. The semiconductor layer 311 of the source structure 310 and the semiconductor layer 341 of the drain structure 340 may include N-type semiconductor doped to a relatively high concentration or P-type semiconductor doped to a relatively high concentration. The semiconductor layer 311 of the source structure 310 and the semiconductor layer 341 of the drain structure 340 may partially extend in the Y direction and may be connected to the channel 320. A part of the semiconductor layer 311 in the source structure 310 and a part of the semiconductor layer 341 in the drain structure 340, the parts being connected to the channel 320, may have the same width as that of the channel 320 in the X direction. Also, another part of the semiconductor layer 311 in the source structure 310 and another part of the semiconductor layer 341 in the drain structure 340, the parts being opposite to the channel 320, may have the widths greater than that of the channel 320.

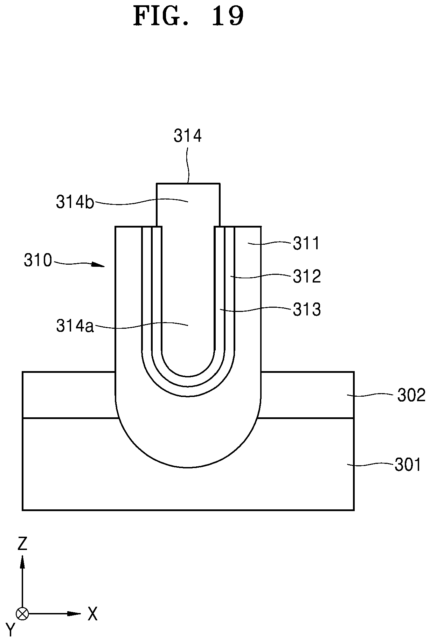

FIG. 19 is a cross-sectional view schematically showing the source structure 310 of FIG. 18, and shows a cross-section of the source structure 310 taken along line A-A' of FIG. 18. Referring to FIG. 19, the source electrode 314 may have a bar shape extending in the Z direction that is different from the direction in which the channel 320 extends. The source electrode 314 may include a first portion 314a located in the semiconductor layer 311 and a second portion 314b protruding from the upper surface of the semiconductor layer 311 in the Z direction. The second silicide layer 313 may be arranged so as to surround the first portion 314a of the source electrode 314 between the semiconductor layer 311 and the first portion 314a of the source electrode 314. In some example embodiments, the first silicide layer 312 may be arranged to surround the second silicide layer 313 between the semiconductor layer 311 and the second silicide layer 313. On the upper surface of the semiconductor layer 311, the second portion 314b of the source electrode 314 may cover at least a part of the second silicide layer 313. To this end, the diameter of the second portion 314b in the source electrode 314 may be greater than that of the first portion 314a. The above structure of the source structure 310 may be identically applied to the drain structure 340.

When the FET 300 of FIGS. 18 and 19 corresponds to the semiconductor device 10 of FIG. 1, the semiconductor layer 11 may include the semiconductor layer 311 of the source structure 310 and the semiconductor layer 341 of the drain structure 340, the first silicide layer 12 may include the first silicide layer 312 of the source structure 310 and the first silicide layer 342 of the drain structure 340, the second silicide layer 13 may include the second silicide layer 313 of the source structure 310 and the second silicide layer 343 of the drain structure 340, and the metal layer 14 may include the source electrode 314 of the source structure 310 and the drain electrode 344 of the drain structure 340.

An example of the FinFET is described with reference to FIGS. 18 and 19, but the source structure 310 and the drain structure 340 of FIGS. 18 and 19 may be applied to other devices than the FinFET, for example, a gate-all-around FET (GAAFET) or a multi-bridge channel FET (MBCFET^{™}).

Also, the semiconductor device according to some example embodiments may be applied to a semiconductor device of a vertical structural type, in which a metal layer is coupled to the side surface of the silicon semiconductor layer.

The semiconductor devices or FETs described above may be used in, for example, a driving integrated circuit of a display, a complementary metal oxide semiconductor (CMOS) inverter, a CMOS SRAM device, a CMOS NAND circuit, and/or other various electronic apparatuses.

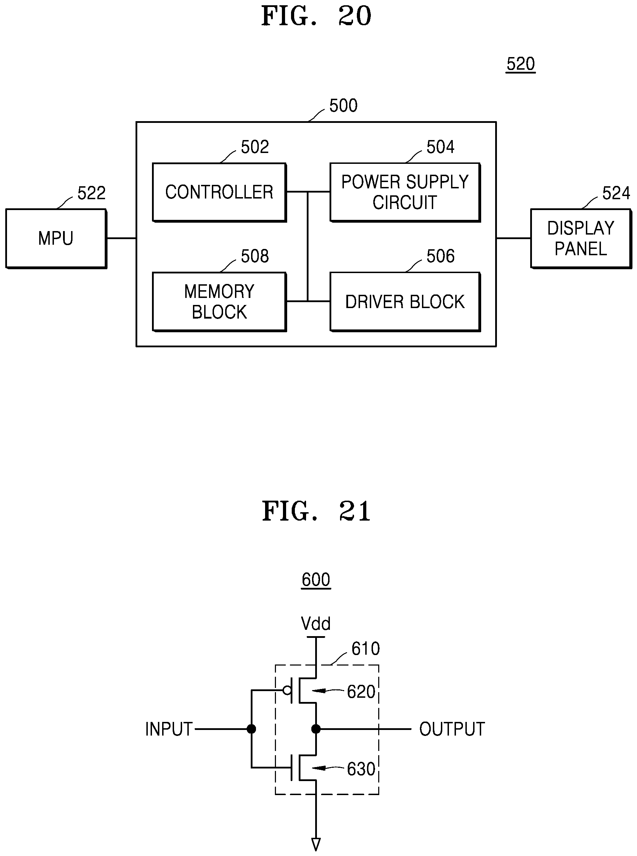

FIG. 20 is a schematic block diagram of a display driver integrated circuit (IC) (DDI) 500 and a display apparatus 520 including the DDI 500, according to some example embodiments. Referring to FIG. 20, the DDI 500 may include a controller 502, a power supply circuit 504, a driver block 506, and a memory block 508. The controller 502 receives and decodes commands applied from a main processing unit (MPU) 522, and controls each block in the DDI 500 for implementing operations according to the commands. The power supply circuit 504 generates a driving voltage in response to the control from the controller 502. The driver block 506 drives a display panel 524 by using the driving voltage that is generated by the power supply circuit 504 in response to the control from the controller 502. The display panel 524 may include, for example, a liquid crystal display panel, an organic light-emitting device (OLED) panel, or a plasma display panel. The memory block 508 is a block for temporarily storing commands input to the controller 502 or control signals output from the controller 502, or for storing required data, and may include a memory such as RAM, ROM, etc. The power supply circuit 504 and the driver block 506 may each include the semiconductor device or FET according to some example embodiments described above with reference to FIGS. 1 to 19.

FIG. 21 is a circuit diagram of a CMOS inverter 600 according to some example embodiments. Referring to FIG. 21, the CMOS inverter 600 includes CMOS transistors 610. The CMOS transistor 610 includes a PMOS transistor 620 and an NMOS transistor 630 connected between a power terminal Vdd and a ground terminal. The CMOS transistor 610 may include the semiconductor device or FET according to some example embodiments described above with reference to FIGS. 1 to 19. For example, either or both of the PMOS transistor 620 or the NMOS transistor 630 may be or correspond to a FET according one or more embodiments described with reference to FIGS. 1 to 19

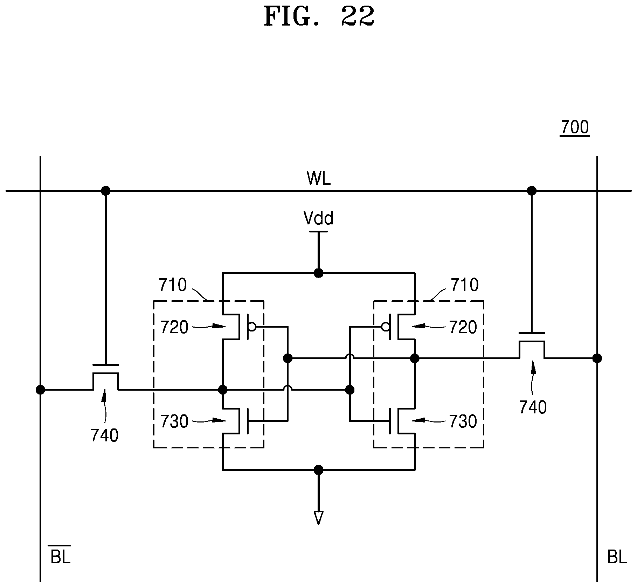

FIG. 22 is a circuit diagram of a CMOS SRAM device 700 according to some example embodiments. Referring to FIG. 22, the CMOS SRAM device 700 includes a pair of driving transistors 710. The pair of transistors 710 each include a PMOS transistor 720 and an NMOS transistor 730 connected between the power terminal Vdd and the ground terminal. The CMOS SRAM device 700 may further include a pair of transfer transistors 740. Sources of the transfer transistors 740 may be cross-connected to common nodes of the PMOS transistor 720 and the NMOS transistor 730 forming the driving transistor 710. The power terminal Vdd is connected to a source of the PMOS transistor 720 and the ground terminal is connected to a source of the NMOS transistor 730. A word line WL may be connected to gates of the pair of transfer transistor 740, and a bit line BL and an inverted bit line may be respectively connected to drains of the pair of transfer transistors 740. At least one of the driving transistor 710 and the transfer transistor 740 of the CMOS SRAM device 700 may include the semiconductor device or FET according to some example embodiments described above with reference to FIGS. 1 to 19.

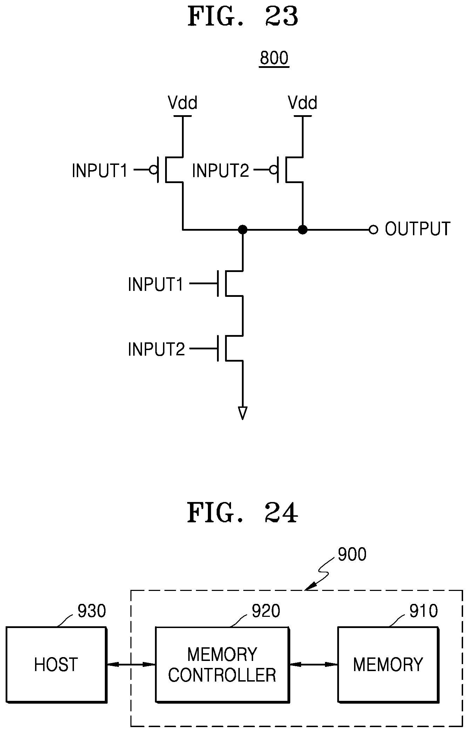

FIG. 23 is a circuit diagram of a CMOS NAND circuit 800 according to some example embodiments. Referring to FIG. 23, the CMOS NAND circuit 800 may include a pair of CMOS transistors to which different input signals are transferred. The CMOS NAND circuit 800 may include the semiconductor device or FET according to some example embodiments described above with reference to FIGS. 1 to 19.

FIG. 24 is a block diagram of an electronic apparatus 900 according to some example embodiments. Referring to FIG. 24, the electronic apparatus 900 includes a memory 910 and a memory controller 920. The memory controller 920 may control the memory 910 in response to a request from a host 930, for reading and/or writing data from/into the memory 910. At least one of the memory 910 and the memory controller 920 may include the semiconductor device or FET according to some example embodiments described above with reference to FIGS. 1 to 19.

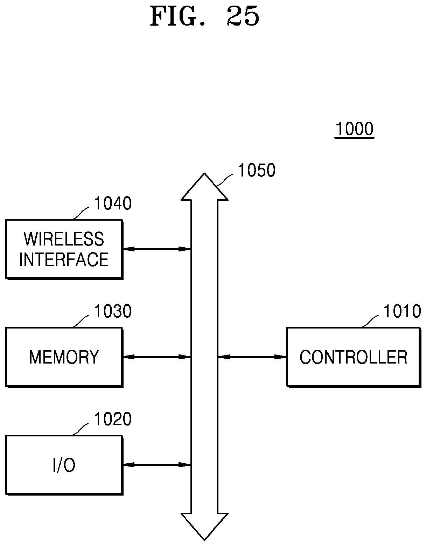

FIG. 25 is a block diagram of an electronic apparatus 1000 according to some example embodiments. Referring to FIG. 25, the electronic apparatus 1000 may configure a wireless communication device or a device capable of transmitting and/or receiving information under wireless environment. The electronic apparatus 1000 includes a controller 1010, an input/output device (I/O) 1020, a memory 1030, and a wireless interface 1040, which are connected to one another via a bus 1050.

The controller 1010 may include a microprocessor, a digital signal processor, or at least one of similar processing devices. The I/O 1020 may include at least one of a keypad, a keyboard, and a display. The memory 1030 may be used to store commands executed by the controller 1010. For example, the memory 1030 may be used to store user data. The electronic apparatus 1000 may use the wireless interface 1040 for transmitting/receiving data via a wireless communication network. The wireless interface 1040 may include an antenna and/or a wireless transceiver. In some example embodiments, the electronic apparatus 1000 may be used in a communication interface protocol of a third-generation communication system, for example, one or more of code division multiple access (CDMA), global system for mobile communication (GSM), north American digital cellular (NADC), extended-time division multiple access (E-TDMA), and/or wide band code division multiple access (WCDMA). The electronic apparatus 1000 may include the semiconductor device or FET according to some example embodiments described above with reference to FIGS. 1 to 18.

The semiconductor device or FET according to some example embodiments may exhibit excellent electrical performance with an ultra-small sized structure and may be applied to an integrated circuit device, and may implement one or more of miniaturization, low power consumption, and high performance.

The semiconductor device according to some example embodiments includes the first silicide layer between the silicon semiconductor layer and the second silicide layer, and thus may accelerate the crystallization of the second silicide layer with reduced thickness and low temperature. As such, the contact resistance of the miniaturized semiconductor device is reduced so as to improve electrical characteristics, and example embodiments may be applied various semiconductor devices.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that various example embodiments described herein should be considered in a descriptive sense only and not for purposes of limitation. Descriptions of features or aspects within each embodiment should typically be considered as available for other similar features or aspects in other embodiments; example embodiments are not necessarily mutually exclusive with one another. While one or more embodiments have been described with reference to the figures, it will be understood by those of ordinary skill in the art that various changes in form and details may be made therein without departing from the scope as defined by the following claims.

## Claims

1. A semiconductor device comprising:
a semiconductor layer including silicon;
a first silicide layer on the semiconductor layer; and
a second silicide layer including titanium and having a crystallization structure on the first silicide layer,
wherein the first silicide layer includes a metal other than titanium, and the second silicide layer includes TiSi₂ having a C54 crystallization structure.

2. The semiconductor device of claim 1, wherein the first silicide layer includes at least one of hafnium silicide, zirconium silicide, nickel silicide, and cobalt silicide.

3. The semiconductor device of claim 1 or 2, wherein the first silicide layer has a thickness in a range from 3 Å to 30 Å.

4. The semiconductor device of any preceding claim, wherein the first silicide layer has a crystallization structure.

5. The semiconductor device of any preceding claim, wherein the second silicide layer has a thickness of 5 Å to 70 Å.

6. The semiconductor device of any preceding claim, wherein the first silicide layer includes at least one of ZrSi, ZrSi₂, Zr₅Si₃, or Zr₃Si₂.

7. The semiconductor device of any preceding claim, wherein the second silicide layer has a Schottky barrier height of 0.7 eV or less.

8. The semiconductor device of any preceding claim, further comprising:
a metal layer on the second silicide layer, and optionally wherein the metal layer includes at least one of magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), argentum (Ag), cadmium (Cd), indium (In), tin (Sn), lanthanum (La), hafnium (Hf), tantalum (Ta), tungsten (W), iridium (Ir), platinum (Pt), aurum (Au), bismuth (Bi).

9. The semiconductor device of claim 8, wherein
the metal layer includes a source electrode on one side surface of a channel layer and a drain electrode facing another side surface of the channel layer,
the second silicide layer includes a 2-1 silicide layer between the source electrode and the channel layer and a 2-2 silicide layer between the drain electrode and the channel layer, and
the first silicide layer includes a 1-1 silicide layer between the 2-1 silicide layer and the channel layer and a 1-2 silicide layer between the 2-2 silicide layer and the channel layer.

10. The semiconductor device of any preceding claim, wherein the semiconductor layer includes at least one of single-crystalline or polycrystalline structure.

11. The semiconductor device of any preceding claim, wherein the first silicide layer is in direct contact with the either the semiconductor layer or the second silicide layer.

12. The semiconductor device of any preceding claim, wherein
the semiconductor layer includes a channel layer, and
the semiconductor device further comprises a gate insulating layer on an upper surface of the channel layer, and
a gate electrode on the gate insulating layer.

13. A method of manufacturing a semiconductor device, the method comprising:
forming a semiconductor layer including silicon;
forming a first silicide layer on the semiconductor layer;
forming a second silicide layer including titanium on the first silicide layer; and
crystallizing the second silicide layer,
wherein the first silicide layer includes a metal other than titanium, and the second silicide layer includes TiSi₂ having a C54 crystallization structure.

14. The method of claim 13, wherein the first silicide layer includes ZrSi, ZrSi₂, Zr₅Si₃, or Zr₃Si₂.

15. The method of claim 13 or 14, wherein the second silicide layer has a C54 crystallization structure within a range of 200°C to 400°C.
